# EUROPEAN PATENT APPLICATION

(11) **EP 1 804 282 A1**
(43) Date of publication of application: **04.07.2007**
(21) Application number: 05078031.1
(22) Date of filing: 29.12.2005
(51) Int. Cl.: H01L 21/308, H01L 21/033, H01L 21/8244, H01L 27/11

(54) **Methods for manufacturing dense integrated circuits**

(71) Applicant: Interuniversitair Microelektronica Centrum vzw ( IMEC), 3001 Leuven (BE)
(72) Inventor: Nackaerts, Axel, 3053 Haasrode (BE); Verhaegen, Staf, 2580 Putte (BE); Witters, Liesbet, 3078 Everberg (BE)
(74) Representative: Bird, William Edward

(57) **Abstract**

This document describes a method for forming integrated circuits comprising devices and circuits obtained therewith. The method of forming a circuit pattern (100) in a device layer (320) of a semiconductor substrate (300), comprising decomposing the circuit pattern (100) in two constituent orthogonal subpatterns (200, 210), transferring the pattern of a first subpattern to a hard mask layer (330, 500) overlying the device layer (320), transferring the pattern of the other subpattern to a photosensitive layer (350) overlying the patterned hard mask layer (330, 500), patterning the device layer (320) using the patterned hard mask layer (330, 500) and the patterned photosensitive layer (350) as a mask, and removing the patterned hard mask layer (330, 500) and the patterned photosensitive layer (350). Furthermore memory or logic circuits obtained using the above technique are described.

## Description

### Technical field of the invention

The present invention relates to methods for manufacturing semiconductor devices, in particular to methods and means for manufacturing dense integrated circuits, e.g. dense integrated circuits comprising fin-based transistor devices such as e.g. finFET devices, using double lithographic exposure techniques and integrated circuits and device made therewith.

### Background of the invention

FinFET devices are known. A finFET comprises a source region, a drain region, a channel region in the form of fin connecting source and drain region and a gate electrode overlying and controlling the conductivity of the channel. The fin is made of a semiconducting material and protrudes from the underlying substrate. Whereas in planar or bulk MOS devices the width of the channel connecting drain and source regions under control of a gate electrode is determined by the width of the active region in which the planar devices are made, the width of a FinFET device is, in first instance, determined by the height of the sidewalls of the fin. Various methods are known in the art to manufacture finFET devices. The idea of making a double gate transistor by using the sidewalls of a dry-etched silicon (Si) fin as conducting channels was already published in 1998 by D. Hisamoto et al. in "A folded-channel MOSFET for deep-sub-tenth Micron Era" in the IEDM Technical Digest 1998 pp 1032-1034. United States application US 6,709,982 discloses a method for manufacturing finFET using spacer technology. According to this disclosure the dimensions of the semiconductor fin are not defined by the dimensions of a pattern defined in a photosensitive layer overlying the semiconductor material using lithographic processing, but by spacers formed in a masking material overlying the semiconductor material. Such spacer-defined finFET process technology allows manufacturing smaller finFET devices even if a less performing lithographic process is used.

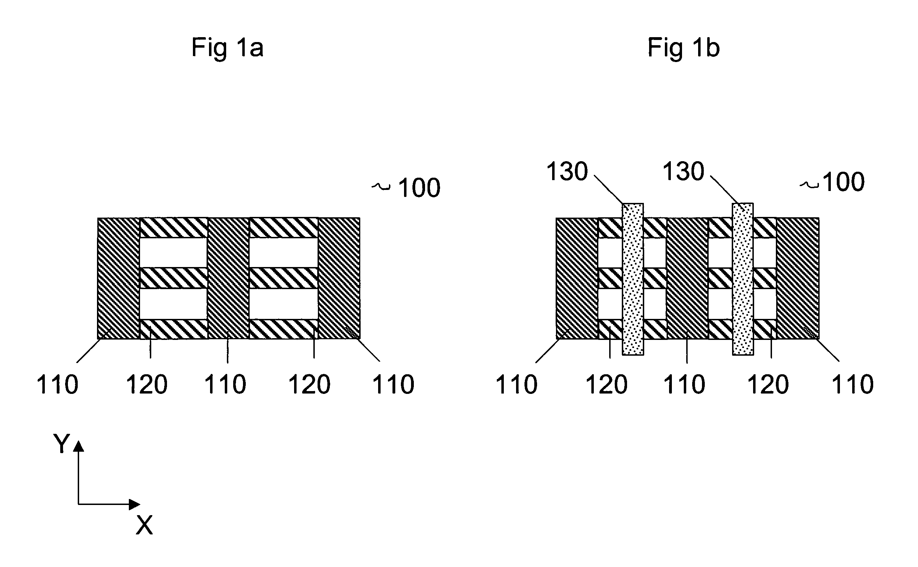

The continuous drive for increased circuit density keeps on pushing for obtaining ever-smaller pitch sizes: smaller devices are to be made which are located at smaller spacing's. Meeting these stringent dimensional requirements is not straightforward. Even when using state-of-the-art lithographic processes, one can not assure that the dense circuit can be accurately printed. One therefore has to modify the layout of the dense circuit or the processing steps such that the layout or the processing is compliant with the lithographic technology available. Fig. 1 a shows a schematic top-view of a prior art circuit (100) after forming the source/drain regions (110) and the fins (120) while fig. 1 b shows the same circuit after forming the gate electrodes (130). Typically fins (120) and source/drain regions (110) are defined during the same patterning step in the same semiconductor material. The circuit shown consists of six finFET devices sharing the source/drain region (110) in the middle, while each group of three finFET devices shares the outer source/drain region (110).

Dense circuits can be manufactured by using a litho-friendly layout. Several of such litho-friendly layouts are known in the art.

One litho-friendly layout style comprises uni-directionally forming of the fins and of the gate electrodes. The semiconductor fins, constituting the channel regions, are aligned to each-other along one direction. Likewise the gate electrodes, formed in e.g. polycrystalline silicon, are aligned to each-other along another direction, which direction is substantially perpendicular to the direction of the fins. One can then apply a lithographic process comprising off-axis illumination, e.g. dipole illumination, and select the process settings giving the best lithographic performance for each uni-directional layout at respectively the fin and the gate level. Although this approach allows forming dense circuits, as only lithographic optimization for one direction at each critical level is to be obtained, this approach has several drawbacks. The same lithographic process is used for all types of circuits and hence the illumination choice for dense circuits, e.g. memory cells, also impacts the design of less dense circuits, e.g. logic circuits. As circuits with different density have to be co-integrated on the same substrate, all circuits require a layout in the above mentioned uni-directional fashion thereby restricting the designers' freedom in lay-outing an electron circuit. Another drawback of having a uni-directional layout at respectively the fin and the gate level is that the parallel semiconductor fins can no longer be connected at the level of the fins themselves as no semiconductor material is present in a direction offset from the chosen fin direction. Therefore such uni-directional layout necessitates providing contact regions on every finFET device as well as additional metal wiring for connecting finFET devices at these contact regions. For the circuit shown in Figs. 1 a and 1 b it would mean that only the semiconductor fins (120) and the polylines (130) are patterned while the source/drain regions (110) providing access to the fins (120) and contact between adjacent fins (120) are absent.

Instead of using a uni-directional layout allowing printing of a pattern in a single optimized lithographic process step, one can perform multiple lithographic process steps, each step being optimized for printing a part of the circuit in the same photosensitive layer. Double exposure techniques are known in the art. European patent application EP 1 385 052 discloses a method wherein a pattern comprising vertical and horizontal oriented elements is printed on a substrate by forming a vertical component mask and a horizontal component mask. The vertical component mask is printed using X-pole illumination, while the horizontal component mask is printed using Y-pole illumination. In this approach a circuit is designed having elements in two orthogonal directions. The design of a circuit is then split in two subdesigns: a first subdesign containing the circuit elements which are directed along a first direction, while the second subdesign contains the circuit elements which are directed along a second direction perpendicular to the first direction. Each subdesign is then printed in the same photosensitive layer using a lithographic process optimized for the corresponding direction. One possible illumination arrangement for double exposures is the double dipole illumination. Here the pattern of the circuit is split up and a corresponding position of the dipole with respect to the direction to be printed is selected such that e.g. in the first exposure a high resolution is obtained for horizontal lines and in the second exposure a high resolution is obtained for vertical lines. If e.g. a positive tone resist is used, the resist will be removed where there is an open area either in the first pattern and/or in the second pattern. The combined lithographic processing then yields the print of the complete circuit. Although this approach gives the designer more freedom in layouting a circuit and independent optimization of the lithographic process for either direction, this approach suffer from some drawbacks as illustrated by Fig. 1a. When printing a first pattern of the horizontal fins (120) in the resist layer, all resist outside the area of the fins (120) will be exposed. If e.g. the area corresponding to the middle source/drain (110) is not included in this first pattern, the corresponding resist area is exposed. When printing a second pattern of the vertical source/drain regions (110) the exposed area of the middle source/drain region (110) can not be repaired and hence only the outer source/drain regions of the circuit in Fig. 1 a can be printed. If the vertical line defining the middle source/drain region is to be printed together with the horizontal lines of the fins, it will worsen the dimensional control of these horizontal lines due to corner rounding effects and line-end shortening.

In the above prior art processes the fins (120) of the circuit (100) were defined by lithographic processing having the drawbacks as discussed. Alternatively one could manufacture the fins (120) by spacer-defined technology as outlined previously. However also, spacer-defined fins will suffer from limitations in the design printable. In this alternative approach semiconductor fins are defined by spacers which are formed adjacent a pattern on top the semiconductor material. As this pattern separates spacers formed at opposite sides thereof, no connection in the semiconductor material can be made between fins defined by these opposite side spacers. Hence additional contact regions and metal wiring has to be provided to contact these fins when required by the configuration of the electronic circuit.

### Summary of the invention

It is an object of the present invention to provide methods for manufacturing dense integrated circuits, such as e.g. dense integrated circuits comprising fin-based transistor devices, e.g. comprising finFET devices. It is an advantage of embodiments of the present invention that they solve the need for semiconductor processes for manufacturing of dense integrated circuits comprising e.g. finFET devices. It is an advantage of preferred embodiments of the present invention that these provide semiconductor processes that reduce the number of contact regions and/or metal wiring needed for connecting finFET devices as required by the configuration of these integrated circuits.

The above objectives are accomplished by a method and device according to embodiments of the present invention.

The present invention relates to a method of forming a pattern in a substrate, the pattern having elements oriented along at least a first direction and elements oriented along a second direction, said first direction being substantially orthogonal to said second direction, the method comprising forming a hard mask layer on the substrate, forming in the hard mask layer a pattern of elements oriented in said first direction, lithographic processing the substrate with a pattern of elements oriented in the second direction, and etching the substrate. A hard mask layer preferably is a layer that is not sensitive to an illumination step in a lithographic process, i.e. a layer that is not photosensitive, and that preferably may be removed selectively with respect to materials of the substrate.

The method furthermore may comprise, prior to said forming a pattern in the hard mask layer, generating a first mask comprising elements of the pattern oriented in said first direction. The method furthermore also may comprises, prior to said lithographic processing the substrate, generating a second mask comprising elements of the pattern oriented in said second direction. Said first mask may be suitable for forming in the hard mask layer a pattern of elements oriented in said first direction. Said second mask may be suitable for lithographic processing the substrate with a pattern of elements oriented in the second direction.

The step of forming in the hard mask layer a pattern of elements oriented in said first direction may comprise patterning the hard mask layer according to an intermediate pattern, forming another hard mask layer overlying the hard mask layer patterned according to an intermediate pattern, forming sidewall spacers against the hard mask layer patterned according to an intermediate pattern and removing the hard mask layer patterned according to an intermediate pattern.

Alternatively, the step of forming in the hard mask layer a pattern of elements oriented in said first direction may comprise forming a photosensitive layer over the hard mask layer, exposing the photosensitive layer with the pattern of elements oriented in said first direction, and etching the hard mask layer.

The step of lithographic processing the substrate may comprise forming a photosensitive layer over the patterned hard mask layer and exposing the photosensitive layer with the pattern of elements oriented in the second direction.

Forming the pattern in a substrate may comprise or consist of forming a local interconnect between two elements of an integrated circuit. A local interconnect may be a connection between two elements of a circuit whereby the connection between the elements is not performed via a metal layer part of the wiring scheme. In other words, a local interconnect may be a connection between two elements of a circuit whereby the connection between the elements is performed in device layer materials, i.e. outside metal layer parts of the wiring scheme. A local interconnect may be a connection between two elements of a circuit being present in the same material layer in which the elements are made and/or in a neigbouring layer in which the elements are made. A local interconnect may be a connection made in the front-end of line processing of the circuit. The two elements of an integrated circuit may be two elements made of a same device layer and said local interconnect is made in said same device layer. The local interconnect also may be made in a device layer neighbouring the device layer wherein at least one of the elements is made. Said device layer may be a semiconductor layer. The local interconnect may be a direct connection between elements. It may be completely formed in one of said device layers.

The integrated circuit may comprise a fin-based transistor element, the integrated circuit comprising fin regions, wherein said fin regions are connected by said local interconnect formed in a semiconducting layer. Said local interconnect then may be referred to as contact pad region. Said local interconnect may connect e.g. two fin regions, a fin region with a control region, e.g. gate region, of a transistor or two control regions, e.g. two gate regions, of a transistor. The substrate may be a semiconductor-on-insulator substrate and the semiconducting layer may be the semiconductor layer of the semiconductor-on-insulator substrate.

The present invention also relates to a method of forming a circuit pattern in a device layer of a semiconductor substrate, the method comprising decomposing the circuit pattern in two orthogonal sub-patterns, transferring the pattern of a first sub-pattern to a hard mask layer overlying the device layer, transferring the pattern of the other sub-pattern to a photosensitive layer overlying the patterned hard mask layer, patterning the device layer using the patterned hard mask layer and the patterned photosensitive layer as a mask, and removing the patterned hard mask layer and the patterned photosensitive layer. Decomposing the circuit pattern in two orthogonal patterns may be performed in an automated way. The two orthogonal sub-patterns may be such that the resulting pattern is the circuit pattern to be formed in the device layer.

The present invention furthermore relates to a memory or logic circuit, the circuit comprising at least one device layer and at least one metal layer for wiring different elements of the circuit, the circuit comprising a plurality of elements made in said at least one device layer, wherein said circuit furthermore comprises a local interconnect connecting at least two elements of said plurality of elements, said local interconnect being formed in one of said at least one device layers. The connection of at least two elements by said local interconnect may be a direct connection, which is completely formed in one of said device layers. A local interconnect may be a connection between two elements of a circuit whereby the connection between the elements is not performed via a metal layer part of the wiring scheme. In other words, a local interconnect may be a connection between two elements of a circuit whereby the connection between the elements is performed in device layer materials, i.e. outside metal layer parts of the wiring scheme. A local interconnect may be a connection between two elements of a circuit being present in the same material layer in which the elements are made and/or in a neigbouring layer in which the elements are made. A local interconnect may be a connection made in the front-end of line processing of the circuit. The two elements of an integrated circuit may be two elements made of a same device layer and said local interconnect is made in said same device layer. The local interconnect also may be made in a device layer neighbouring the device layer wherein at least one of the elements is made. Said device layer may be a semiconductor layer.

The circuit may comprise a plurality of fin-based transistors, said fin-based transistors comprising a fin region and a control electrode, wherein said at least two elements connected by said local interonnect may be any of at least two fin regions, a fin region and a control electrode or at least two control electrodes. Said local interconnect may be referred to as a connection pad. Said fin-based transistors may be finFET devices and said control electrode(s) are gate electrode(s).

The at least two elements may be made in the same device layer. The local interconnect may be made in the same device layer as said at least two elements.

The memory or logic circuit may be a memory circuit. The memory circuit may comprise or consist of a static random access memory cell. The static random access memory cell may comprise a plurality of finFET devices configured to form a bistable element and to form two select transistors T2, T5 for accessing the bistable element, wherein gate electrodes of the two select transistors T2, T5 are connected at a first metal level using a first metal connection running over the SRAM memory cell and wherein connections between respective fins of the bistable element T4-T6, T1-T3 are formed in a same material as wherein said fins are formed.

The static random access memory cell may comprise two invertors T4-T6, T1-T3 comprising transistors T1, T3, T4 and T6, and two pass transistors T5, T2 for contacting the two invertors, whereby transistors T4, T5, T6 share a common pad while transistors T4 and T6 have a common gate electrode, transistors T1, T2, T3 share a common pad while transistors T1 and T3 having a common gate electrode, the gate electrode of transistors T1, T3 being connected with the common pad of transistors T4, T5, T6, the gate electrode of transistors T4, T6 being connected with the common pad of transistors T1, T2, T3, the other pad of nMOS transistors T5 and T2 being connected to bitlines BL, the gate electrodes of both transistors T5 and T2 being connected to a common wordline WL, the pad shared between nMOS transistors T6 and T3 being connected to a ground line Vss, while the pad shared between pMOS transistors T4 and T1 being connected to the supply voltage line Vdd, characteristed in that the connection between the gate electrode of transistors T1, T3 and the common pad of transistors T4, T5, T6, and the connection between the gate electrode of transistors T4, T6 and the common pad of transistors T1, T2, T3 is formed in a device layer, and the connection between the gate electrodes of both transistors T5 and T2 and a common wordline WL being formed in a first metal level.

The present invention also relates to a method of manufacturing a memory or logic circuit, the memory or logic circuit comprising a plurality of elements oriented in a first direction and elements oriented in a second direction, said first direction being substantially orthogonal to said second direction, said plurality of elements made in at least one device layer and at least one metal layer for wiring different elements of the circuit,
the method comprising, forming a hard mask layer on the substrate, forming in the hard mask layer a pattern of elements oriented in said first direction, lithographic processing the substrate with a pattern of elements oriented in the second direction, and etching the substrate, wherein one of said elements oriented in a first direction or said elements oriented in a second direction are local interconnects between elements made in the at least one device layer.

Particular and preferred aspects of the invention are set out in the accompanying independent and dependent claims. Features from the dependent claims may be combined with features of the independent claims and with features of other dependent claims as appropriate and not merely as explicitly set out in the claims.

Embodiments of the present invention may result in the provision of efficient, stable and/or reliable methods for manufacturing dense integrated circuits.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1a and Fig. 1b are schematic top views of different stages during manufacturing of a known circuit illustrating the drawbacks of the prior art processes.
Fig. 2a-c shows the decomposition of the layout of a circuit at fin level into two subdesigns according to a first embodiment of the invention.
Fig. 3a-e shows schematic top views and corresponding cross-sectional views (A-A) illustrating a method for manufacturing the integrated circuit of Fig. 2a.
Fig. 4a-c shows the decomposition of the layout of a circuit at fin level into two subdesigns according to a second embodiment of the invention.
Fig. 5a-e shows schematic top views and corresponding cross-sectional views (A-A) illustrating a method for manufacturing the integrated circuit of Fig. 4a.
Fig. 6 a-d shows an electrical equivalent circuit (a) and schematic views (b, c, d) to illustrate a third embodiment of the invention.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Throughout the description the terms "horizontal" or "X-direction" and "vertical" or "Y-direction" are used to identify two perpendicular directions in a pattern. The terms "horizontal" and "vertical" should therefore not be interpreted as absolute directions but as a way to allow distinguishing elements of pattern according to their relative position which can be parallel to each-other or in a relative perpendicular orientation.

With lithographic patterning is meant the steps of depositing a layer of photosensitive material or resist, exposing this layer according to a pattern to transfer this pattern into the photosensitive material and developing the exposed photosensitive material. When positive resist is used the exposed photosensitive material is removed during development. The invention is not limited to the use of positive resist. E.g. negative resist can be used, wherein the non-exposed photosensitive material is removed during development. The exposure according to a pattern can be exposure of the photosensitive material through a mask or reticle containing the pattern as is done in optical lithographic processing, or by reflecting light via a mask or reticle containing the pattern towards the photosensitive material e.g. as is done in extreme ultraviolet lithography (EUV) or by direct writing the pattern into the photosensitive material e.g. as is done in e-beam lithography.

It is to be noted that with "substrate" reference is made to a carrier and a layer which need to be provided with the layout according to the design. Providing a design on/in a substrate thus corresponds with providing a design in a layer which needs to be provided with the layout according to a selected design.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

Reference will be made to transistors. These are three-terminal devices having a first main electrode such as a drain, a second main electrode such as a source and a control electrode such as a gate for controlling the flow of electrical charges between the first and second main electrodes.

It will be clear for a person skilled in the art that the present invention is also applicable to similar devices that can be configured in any transistor technology, including for example, but not limited thereto, CMOS, BICMOS, Bipolar and SiGe BICMOS technology. Furthermore the findings of the present invention are explained with reference to PMOS and NMOS transistors as an example, but the present invention includes within its scope a complementary device whereby PMOS and NMOS transistors become NMOS and PMOS transistors, respectively. A skilled person can make such modifications without departing from the true spirit of the invention.

In a first aspect, the present invention discloses methods to form a pattern, e.g. dense pattern, in a substrate, e.g. in a device layer of a substrate. A device layer can be a semiconductor layer, such as a layer of silicon, germanium or an alloy of silicon and germanium, wherein the channel regions and/or source/drain regions are patterned. A device layer can be a conductive layer, such as a layer of polycrystalline silicon or a metal, e.g. aluminum, tantalum or tantalum nitride, titanium or titanium nitride, wherein the gate electrodes are patterned. A device layer can be a dielectric layer such as a layer of a low-k dielectric, e.g. porous silicon oxide, wherein trenches are formed in damascene processing which trenches are filled with metal to form a metallic wiring scheme. The method for forming a pattern in a substrate is especially suitable for forming a pattern having elements oriented along at least a first direction and elements oriented along a second direction wherein the first direction and the second direction are substantially orthogonal. The method comprises forming a hard mask layer on the substrate, wherein the hard mask layer may be a layer that is not photosensitive, e.g. a layer that is not a resist layer. The method furthermore comprises forming in the hard mask layer a pattern of elements oriented in the first direction and lithographic processing of the substrate with a pattern of elements oriented in the second direction. The method furthermore comprises etching the substrate, resulting in a pattern on the substrate. The step of decomposing the pattern in two subpatterns, each subpattern containing parts of the pattern that are oriented to substantially the same direction, one subpattern being orthogonal to the other subpattern may be either part of the method or may be performed separately. Once the decomposed pattern is obtained, the method of the present invention may be performed by, in a first patterning step, transferring one of the two subpatterns to a hard mask layer overlying the device layer, in a second patterning step, transfering the other of the two subpatterns to a resistlayer overlying the patterned hard mask layer and in a third patterning step, etching the device layer using the patterned hard mask layer and patterned resist layer yielding the dense pattern in the device layer. The method of the first aspect will be illustrated by way of different embodiments, the present invention not being limited thereto.

In a first embodiment of the invention a method is disclosed to provide a pattern for an integrated circuits comprising a dense pattern, such as e.g. a pattern for an integrated circuit. The integrated circuit may be e.g. a memory or logic circuit comprising fin-based transistors devices, like e.g. finFET (field effect transistor) devices. By way of illustration the method will be shown for an integrated circuit comprising a fin-based transistor, the invention not being limited thereto. Lithographic processing is used to define the fin of the finFET devices. In the example provided, connective regions, also known as local interconnects, are formed in the same layer as the fins of the finFET devices.

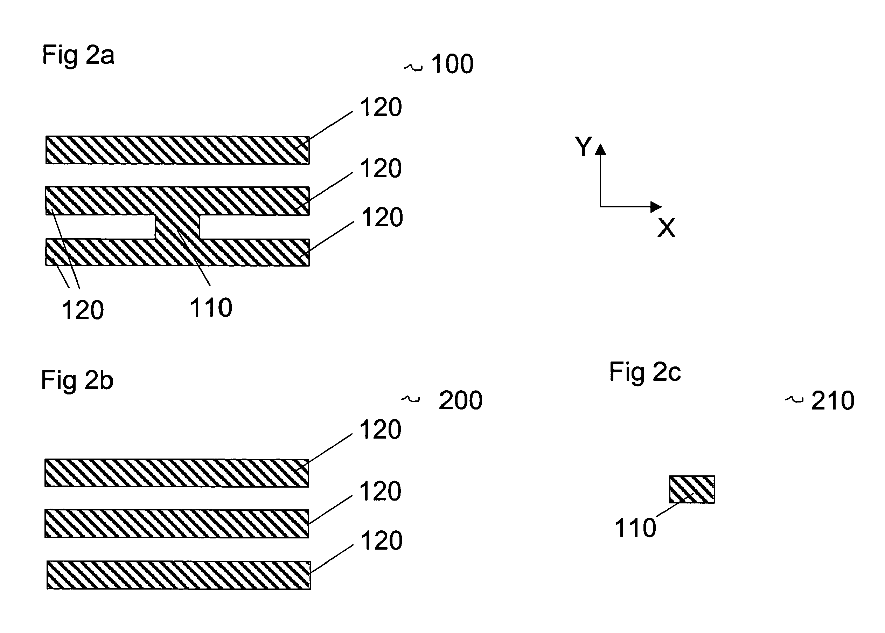

In order to teach the invention the layout of a circuit at fin level is shown in fig. 2a. This layout shows the pattern to be formed in the semiconductor layer (320) in order to obtain fins (120) and first and second electrode regions (110), such as e.g. source/drain regions (110), as part of this circuit (100). The layout of this exemplary circuit (100) contains five fins (120), four of which have a first and second electrode regions (110), such as e.g. a source/drain region (110) in common in the middle of the circuit (100). This first and second electrode region (110), such as e.g. source/drain region (110), also known as pad, can be used to contact these four fins. The pattern shown in fig. 2a may be first decomposed in two subpatterns or a decomposed pattern may be obtained or received. The patterns may be constituent. The patterns also may be such that the resulting image obtained is the pattern to be formed. A first subpattern (200) contains the pattern corresponding a first direction, e.g. to the horizontal elements (X-direction) of the circuit (100) at fin level. In this example the first subpattern (200) contains the fins (120). A second subpattern (210) contains the pattern corresponding to a second direction, perpendicular to the first direction, e.g. to the vertical elements (Y-direction) of the circuit (100) at fin level. In this example the second subpattern (210) contains the common pad (110). At this level the circuit pattern (100) is used to generate two masks (200, 210), each of these two masks (200, 210) containing that part of the pattern that is oriented along one of two perpendicular directions.

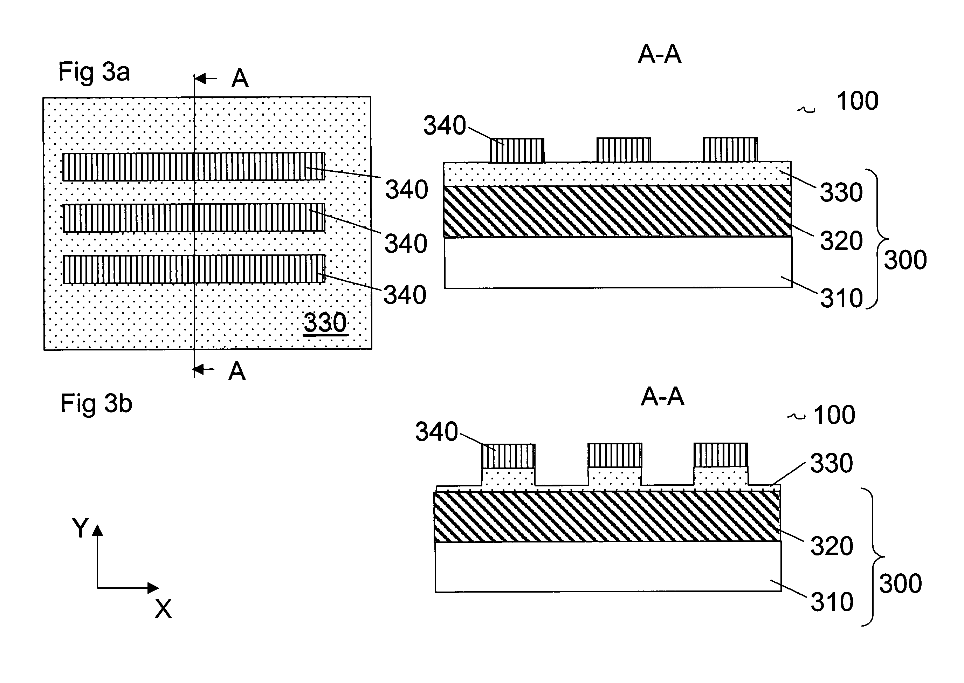

Figs. 3a-e illustrate a method for manufacturing the layout of fig. 2a using the subpatterns of fig. 2b and fig. 2c. Figs. 3a-e show schematic cross-sectional views A-A (right) and, where appropriate, corresponding top views (left) illustrating process steps in a method according to this first embodiment.

A substrate (300) is provided. This substrate (300) can be a semiconductor substrate such as a silicon or a germanium wafer. Preferably this substrate is a semiconductor-on-insulator substrate (300) comprising a semiconductor layer (320) formed on a dielectric layer (310), e.g. a layer of siliconoxide. The semiconductor layer can comprise silicon, germanium or an alloy of silicon or germanium. This substrate can be a silicon-on-insulator wafer wherein the semiconductor layer (310) is a silicon layer. This substrate can be a germanium-on-insulator wafer wherein the semiconductor (320) is a germanium layer. In this semiconductor layer (310) the fins (120) and the pads (110) of the circuit (100) are to be patterned. On the semiconductor layer (320) a hard mask layer (330) is formed. This hard mask layer (330) can be removed selectively to the semiconductor layer (320) and to the dielectric layer (310). This hard mask layer can be formed from silicon nitride, silicon carbide or silicon oxynitride.

In a first patterning step the pattern of one of the two subpatterns (200, 210) is transferred to this hard mask layer (330). Which subpattern is selected might depend on the minimal dimension present in a subpattern. One can select to use the most critical subpattern, i.e. the subpattern having the minimal feature size, in this first patterning step. Fig. 3a shows the substrate (300) comprising a semiconductor layer (320) overlying a dielectric layer (310). Overlying the semiconductor layer (320) is a layer of a hard mask layer (330). A layer of a photosensitive material (340) is deposited on the hard mask layer (310). This resist layer (340) is lithographic patterned using the subpattern (200) containing the horizontal elements. As shown in the top view (left of fig. 3a) the resist layer (340) is patterned to form three resist stripes corresponding to the fins (120) of the overall layout of the circuit (100). As in this subpattern (200) only elements in the same direction are present appropriate illumination conditions can be selected, such as off-axis illumination, e.g. dipole or quadruple illumination, numerical aperture, focus, energy, whether immersion lithographic processing is to be applied. Selecting these parameters allows obtaining a tight pitch, i.e. the distance between the stripes of resist, and a controlled dimension, i.e. the width of these resist stripes. Hence a dense circuit can be formed. After lithographic patterning the first resist layer (340) the underlying hard mask layer (330) is patterned using the patterned first resist layer (340) as a masking layer. Preferably an anisotropic dry etch process is used to selectively remove exposed parts of the hard mask layer (330). One can choose to remove all or part of the hard mask material in the exposed regions. Fig. 3b shows the device after this first etching step. Here, the hard mask layer (330) is only partially etched such that topography of stripes is created in this layer corresponding to the three fins (120) of the circuit.

In a second patterning step the pattern of the other subpattern (200, 210) is transferred to a resist layer overlying the patterned hard mask layer (330). In this example the subpattern (210) containing the vertical elements (110) is used in the second patterning step. As shown in fig. 3c a second resist layer (350) is deposited overlying the patterned hard mask layer (330). This second resist layer (350) is lithographically patterned using a mask containing the second subpattern (210). Again the lithographic process parameters of this second patterning step can be selected in view of the pattern to be formed. This second lithographic patterning step can be formed on the same lithographic tool or a different lithographic tool. In this example the second pattern (210), orthogonal to the first pattern (200), is only used to define a connection (110) between elements (120) of the first pattern (200) in the same device layer (320). The requirements to the lithographic process for this second patterning step can be relaxed compared to the first patterning step. As the method of the first embodiment allows establishing this connection at the device level, no additional contacts or metal wiring is to be provided later on in the semiconductor process flow when forming the complete integrated circuit. In other words a local interconnect between elements of the integrated circuit may be formed in at least one of the device layers. The at least one of the device layers may be the device layers in which at least one of the elements is made or a neighbouring layer thereof. The fins to be connected can be positioned at smaller pitches thereby increasing the overall density of the circuit. As shown in the top view (left) of fig. 3c the complete layout of the circuit at fin level as shown in fig. 2a is now present on the substrate either in the topography of the patterned hard mask layer (340) or in the topography of the lithographic patterned second resist layer (350). As first the pattern information of one subpattern is transferred to a layer (340) which is insensitive to lithographic processing, the pattern information of the other subpattern can subsequently be transferred to a photosensitive layer (350) independently of the first transferred subpattern. One pattern transfer doesn't affect the other pattern transfer.

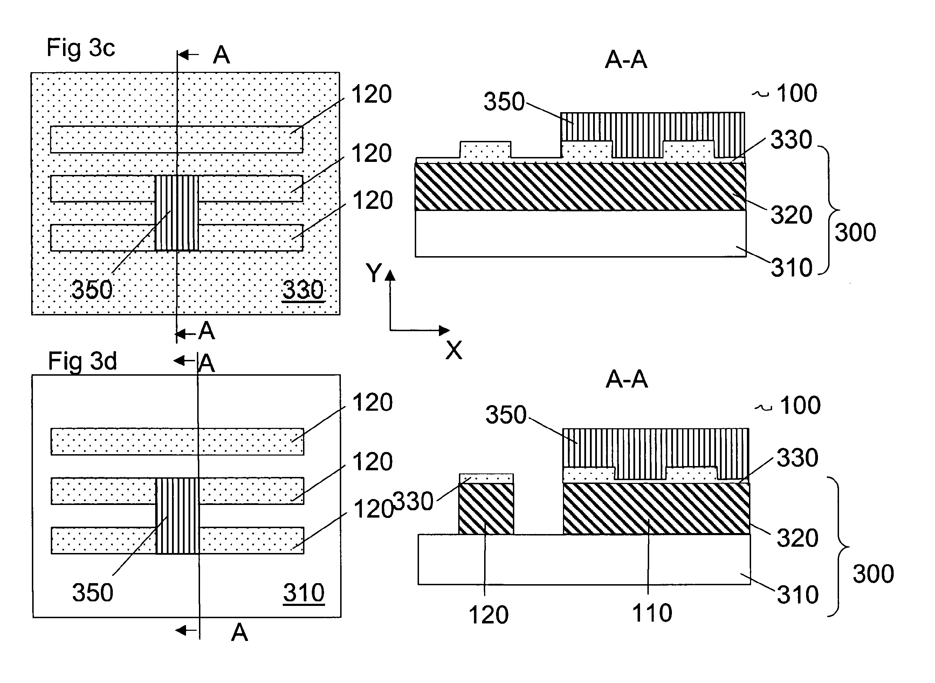

Finally the semiconductor layer (320) is patterned through the pattern in the patterned hard mask layer (330) and the pattern in the lithographic patterned second resist layer (350). Preferably an anisotropic dry etch is used to selectively remove the exposed semiconductor material (320). This patterning step is illustrated in fig. 3d where the top view (left) shows the horizontal stripes constituting the fins (120) and the vertical strip constituting the pad (110) that connects the four fins at the bottom. In the cross-section the left fin is defined by the pattern in the hard mask layer (330) while the pad is defined by resist pattern (350) overlying the patterned hard mask layer (330). The thickness and the material of the hard mask layer (330) are selected to allow selective removal of the semiconductor layer (320) during this patterning step without introducing a too large topography for the second lithographic patterning step. After etching the semiconducting device layer (320) the patterned hard mask layer (330) and the patterned second resist layer (350) are removed selectively towards the patterned device layer (320) and, if present, the underlying dielectric material (310).

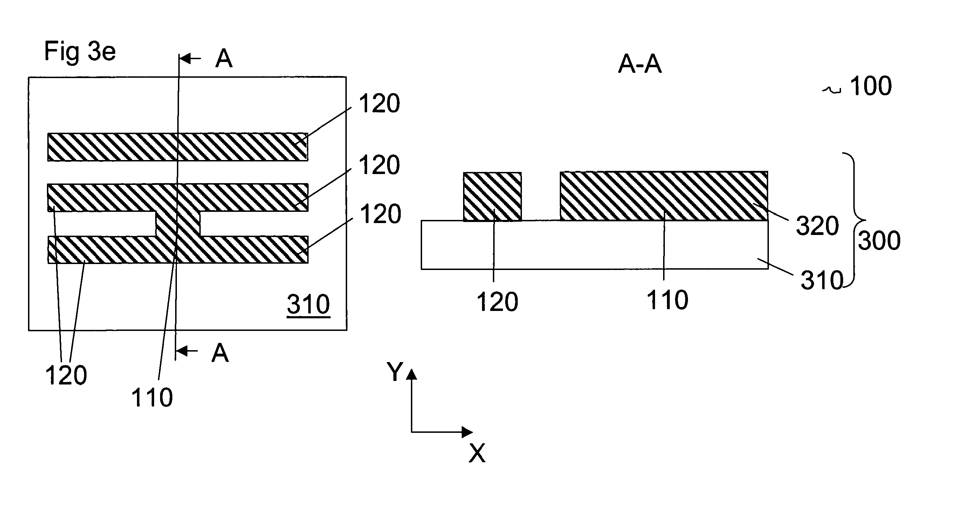

Fig. 3e shows the device (100) after completing the processing at the level of the fins. The layout of fig. 2a is transferred to the device layer (320).

The processing of the circuit (100) can now continue. Other layers such as control electrodes (130), e.g. gate electrode layer (130), contact layer and interconnect layers will be formed upon te patterned semiconductor layer (320) to form an integrated circuit.

A person skilled in the art will realize that the teaching of this first embodiment is also applicable to other circuits comprising dense structures. The circuits may be memory circuits or logic circuits. In case of memory circuits, the circuits may be any memory circuit, such as a static random access memory, a dynamic random access memory, a Flash memory, etc. The circuits may comprise transistors. The transistors may be fin-based transistors, e.g. finFET devices. In the latter case, the number and location of fins (120) and of first and second electrodes, e.g. source/drain regions (110) can be selected depending to the electronic circuit (100) to be manufactured.

In other words, in the present embodiment the step of forming a pattern of elements oriented in said first direction in the hard mask layer comprises forming a photosensitive layer (340) over the hard mask layer (330), exposing the photosensitive layer (340) with the pattern (200) of elements oriented in said first direction, and etching the hard mask layer (330).

In a second embodiment of the invention a method is disclosed to manufacture integrated circuits comprising a dense pattern, such as e.g. a pattern for an integrated circuit comprising fin-based transistors, like e.g. finFET (field effect transistor) devices. By way of illustration the method will be shown for an integrated circuit comprising a fin-based transistor, the invention not being limited thereto. The fin of the finFET devices are formed using spacer technology. Connective regions are formed in the same layer as the fin of the finFET devices.

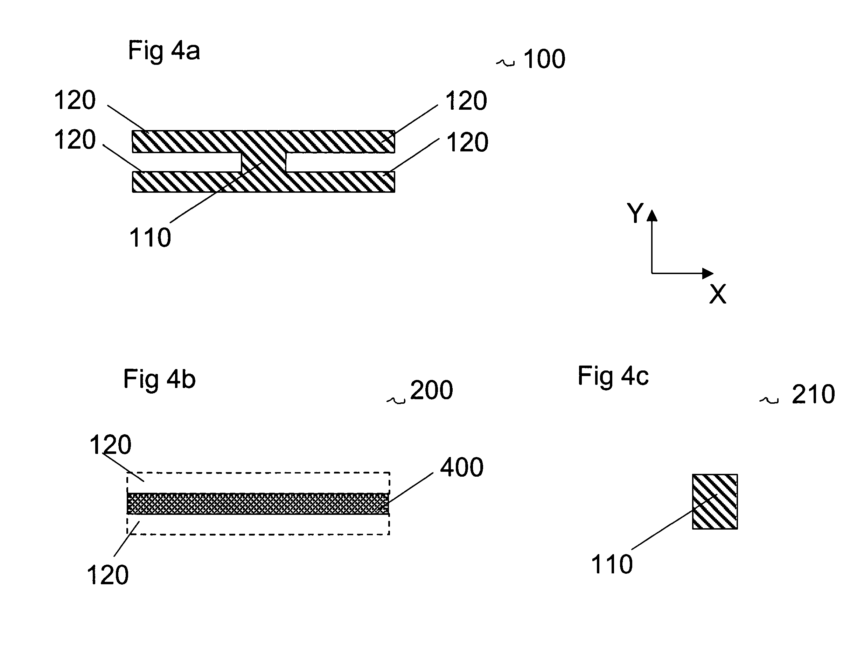

In order to teach the invention the layout of a circuit (100) at fin level is shown in fig. 4a. This layout shows the pattern to be formed in the semiconductor layer (320) in order to obtain fins (120) and first and second electrode, e.g. a source/drain regions (110) if MOSFET technology is applied, as part of this circuit (100). The layout of this exemplary circuit (100) contains four fins (120) having a first and second electrode, e.g. a source/drain region (110) if MOSFET technology is applied, in common in the middle of the circuit (100). This first and second electrode, e.g. a source/drain region (110), also known as pad, can be used to contact these four fins. The pattern shown in fig. 4a is first decomposed in two constituent subpatterns. A first subpattern (200) contains the pattern corresponding to a first direction, e.g. to the horizontal elements (X-direction) of the circuit (100) at fin level. In this example the first subpattern (200) contains a strip (400) which defines the position of the four fins (120) which are indicated by the dotted squares. As in the second embodiment the fins are defined by spacer technology, the pattern information on the first subpattern (200) defines the position of the intermediate pattern (400) against which the spacers (500) will be formed corresponding to the position of the fins (120). A second subpattern (210) contains the pattern corresponding to a second direction, perpendicular to the first direction, e.g. to the vertical elements (Y-direction) of the circuit (100) at fin level. In this example the second subpattern (210) contains the common pad (110). At this level the circuit pattern (100) is used to generate two masks (200, 210), each of these two masks (200, 210) containing that part of the pattern that is oriented along one of two perpendicular directions.

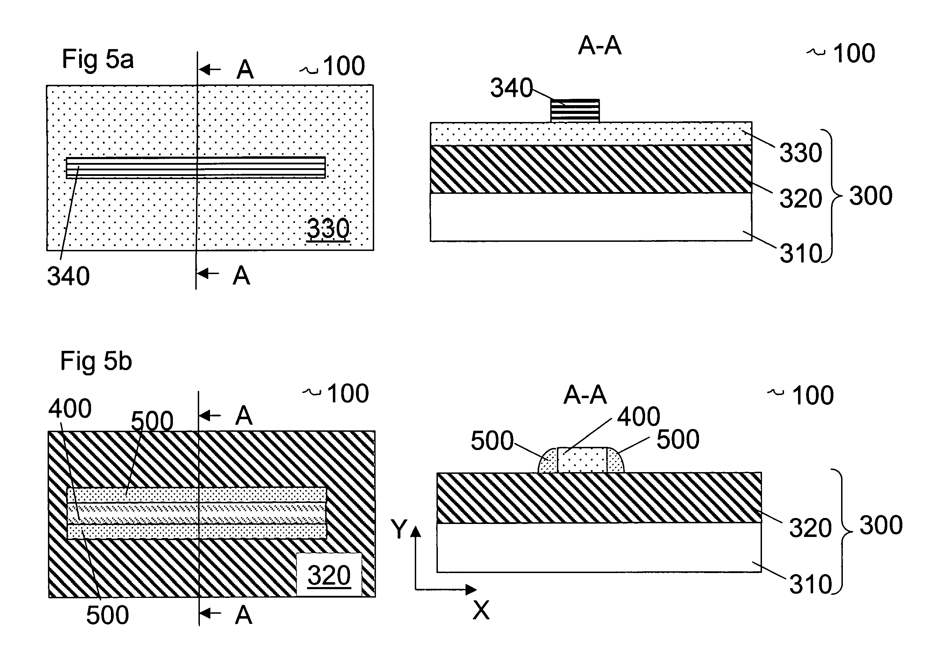

Figs. 5a-e illustrate a method for manufacturing the layout of fig. 4a using the subpatterns of fig. 4b and fig. 4c. Figs. 5a-e show schematic cross-sectional views A-A (right) and, where appropriate, corresponding top views (left) illustrating process steps in a method according to this first embodiment.

A substrate (300) is provided. This substrate (300) can be a semiconductor substrate such as a silicon or a germanium wafer. Preferably this substrate is a semiconductor-on-insulator substrate (300) comprising a semiconductor layer (320) formed on a dielectric layer (310), e.g. a layer of siliconoxide. The semiconductor layer can comprise silicon, germanium or an alloy of silicon or germanium. This substrate can be a silicon-on-insulator wafer wherein the semiconductor layer (310) is a silicon layer. This substrate can be a germanium-on-insulator wafer wherein the semiconductor (320) is a germanium layer. In this semiconductor layer (310) the fins (120) and the pads (110) of the circuit (100) are to be patterned. On the semiconductor layer (320) a hard mask layer (330) is formed. This hard mask layer (330) can be removed selectively to the semiconductor layer (320) and to the dielectric layer (310). This hard mask layer can be formed from silicon nitride, silicon carbide or silicon oxynitride.

In a first patterning step the pattern of the subpatterns (200) is transferred to this hard mask layer (330). Fig. 5a shows the substrate (300) comprising a semiconductor layer (320) overlying a dielectric layer (310). Overlying the semiconductor layer (320) is a layer of a hard mask layer (330). A layer of a photosensitive material (340) is deposited on the hard mask layer (310). This resist layer (340) is lithographic patterned using the subpattern (200) containing the horizontal element. As shown in the top view (left of fig. 5a) the resist layer (340) is patterned to form one resist stripe corresponding to the position of the intermediate pattern (400). As in this subpattern (200) only elements in the same direction are present appropriate illumination conditions can be selected, such as off-axis illumination, e.g. dipole or quadruple illumination, numerical aperture, focus, energy, whether immersion lithographic processing is to be applied. Selecting these parameters allows obtaining a tight pitch, i.e. the distance between the stripes of resist, and a controlled dimension, i.e. the width of the resist stripe. Hence a dense circuit can be formed. After lithographic patterning the first resist layer (340), the underlying hard mask layer (330) is patterned using the patterned first resist layer (340) as a masking layer to form the intermediate feature (400). Preferably an anisotropic dry etch process is used to selectively remove exposed parts of the hard mask layer (330). One can choose to remove all or part of the hard mask material in the exposed regions.

After the intermediate feature (400) is formed the resist (340) is stripped. Another hard mask layer is deposited overlying the intermediate feature (400). This second hard mask layer is isotropic etched to form sidewall spacers (500) against the sidewalls of the intermediate feature (400). These sidewall spacers (500) are used as mask to pattern fins (120) in the semiconductor layer (320) in subsequent process steps. The second hard mask layer is formed of material allowing selective removal of the first hard mask layer (330) and of the semiconductor layer (320). Preferably silicon oxide, silicon nitride, silicon carbide or silicon oxynitride is used to form the second hard mask layer. Fig. 5b only shows the sidewall spacers formed along the length of the intermediate feature (400), although also sidewall spacers are formed along the width of this intermediate feature (400).

Fig. 5b shows the device after this first patterning step. Here, the hard mask layer (330) is completely etched to form the intermediate structure (400). This intermediate structure (400) is selectively removed before printing the second subpattern (210).

In a second patterning step the pattern of the other subpattern (210) is transferred to a resist layer overlying the sidewall spacers (500). In this example the subpattern (210) containing the vertical element (110) is used in the second patterning step. As shown in fig. 5c a second resist layer (350) is deposited overlying the sidewalls spacers (500). This second resist layer (350) is lithographically patterned using a mask containing the second subpattern (210). Again the lithographic process parameters of this second patterning step can be selected in view of the pattern to be formed. This second lithographic patterning step can be formed on the same lithographic tool or a different lithographic tool. In this example the second pattern (210), orthogonal to the first pattern (200), is only used to define a connection between elements (120) of the first pattern (200) in the same device layer (320). The requirements to the lithographic process for this second patterning step can be relaxed compared to the first patterning step. As the method of the first embodiment allows establishing this connection at the device level, no additional contacts or metal wiring is to be provided later on in the semiconductor process flow when forming the complete integrated circuit. The fins to be connected can be positioned at smaller pitches thereby increasing the overall density of the circuit. As shown in the top view (left) of fig. 5c the complete layout of the circuit at fin level as shown in fig. 4a is now present on the substrate either in the pattern of the sidewalls spacers (500) or in the topography of the lithographic patterned second resist layer (350). As first the pattern information of one subpattern is transferred to a layer (500) which is insensitive to lithographic processing, the pattern information of the other subpattern can subsequently be transferred to a photosensitive layer (350) independently of the first transferred subpattern. One pattern transfer doesn't affect the other pattern transfer.

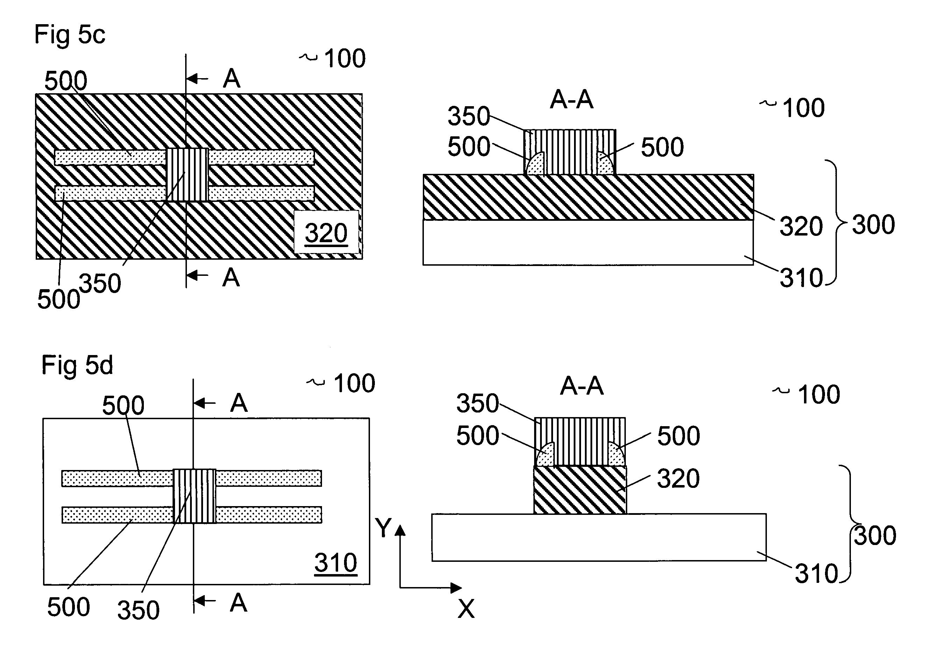

Finally the semiconductor layer (320) is patterned through the pattern of the sidewalls spacers (500) and the pattern in the lithographic patterned second resist layer (350). Preferably an anisotropic dry etch is used to selectively remove the exposed semiconductor material (320). This patterning step is illustrated in fig. 5d where the top view (left) shows the horizontal stripes (500) constituting the fins (120) and the vertical strip constituting the pad (110) that connects the four fins. The thickness and the material of the first hard mask layer (330) and of the second hard mask layer are selected to allow selective removal of the semiconductor layer (320) during this patterning step without introducing a too large topography for the second lithographic patterning step. After etching the semiconducting device layer (320) the sidewall spacers (500) and the patterned second resist layer (350) are removed selectively towards the patterned device layer (320) and, if present, the underlying dielectric material (310).

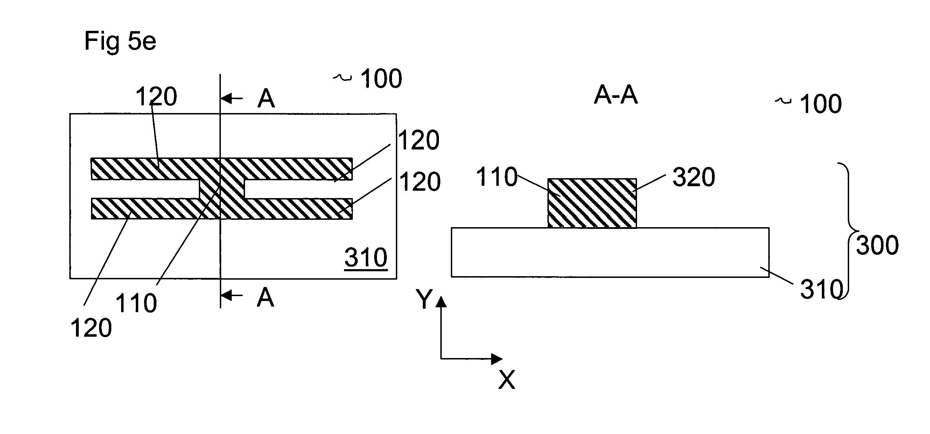

Fig. 5e shows the device (100) after completing the processing at the level of the fins. The layout of fig. 4a is transferred to the device layer (320).

The processing of the circuit (100) can now continue. Other layers such as control electrode, e.g. gate electrode layer (130), contact layer and interconnect layers will be formed upon te patterned semiconductor layer (320) to form an integrated circuit.

Compared to the process sequence illustrated by figs. 3a-e the process sequence illustrated by figs. 5a-e comprises additional steps to form sidewall spacers: depositing a second hard mask layer, forming spacers (500) in this second hard mask layer, removing the intermediate pattern (400) which was used as template to form the sidewall spacers (500).

In the present example, the step of forming in the hard mask layer (330) a pattern of elements oriented in said first direction comprises forming a photosensitive layer (340) over the hard mask layer (330), exposing the photosensitive layer (340) with the pattern (200) of elements oriented in said first direction, and etching the hard mask layer (330).

A person skilled in the art will realize that the teaching of this second embodiment is also applicable to other circuits comprising dense structures. The circuits may be memory circuits or logic circuits. In case of memory circuits, the circuits may be any memory circuit, such as a static random access memory, a dynamic random access memory, a Flash memory, etc. The circuits may comprise fin-based transistors, suh as e.g. finFET devices. The number and location of fins (120) and of first electrode and second electrode regions, e.g. source/drain regions (110) can be selected depending to the electronic circuit (100) to be manufactured.

In a second aspect of the present invention, the invention relates to a memory or logic circuit and a method for manufacturing a memory or logic circuit. The method for manufacturing a memory or logic circuit is based on the method for forming a pattern as described in the first and second embodiment as described above. The memory or logic circuit typically comprises at least one device layer wherein the elements of the circuit are made and at least one metal layer for wiring different elements of the circuit. The circuit furthermore comprises a local interconnect connecting at least two elements of said plurality of elements, said local interconnect being formed in one of said at least one device layers. A local interconnect may provide a direct connection between the elements. The connection may be completely formed in one of said device layers. The circuit may comprise a plurality of fin-based transistors. Such fin-based transistors comprise a fin region, a first and second electrode, e.g. a source and drain electrode if MOSFET technology is used. The fin-based transistors typically also comprise a control electrode, e.g. a gate electrode if MOSFET technology is used. According to the present invention the memory or logic circuit may connect at least two elements connected using a local interconnect whereby the at least two elements are any of at least two fin regions, a fin region and a control electrode or at least two control electrodes. The at least two elements are made in the same device layer and the local interconnect may be made in the same device layer as said at least two elements. The local interconnect may act as a connection pad. The fin-based transistors may be finFET devices and said control electrode(s) are gate electrode(s). The memory or logic circuit may be a memory device, such as a static random access memory, a dynamic random access memory, a flash memory, etc.. It may e.g. be an SRAM comprising finFET devices. The second aspect of the present invention will be further illustrated in specific embodiments, the present invention not being limited thereto.

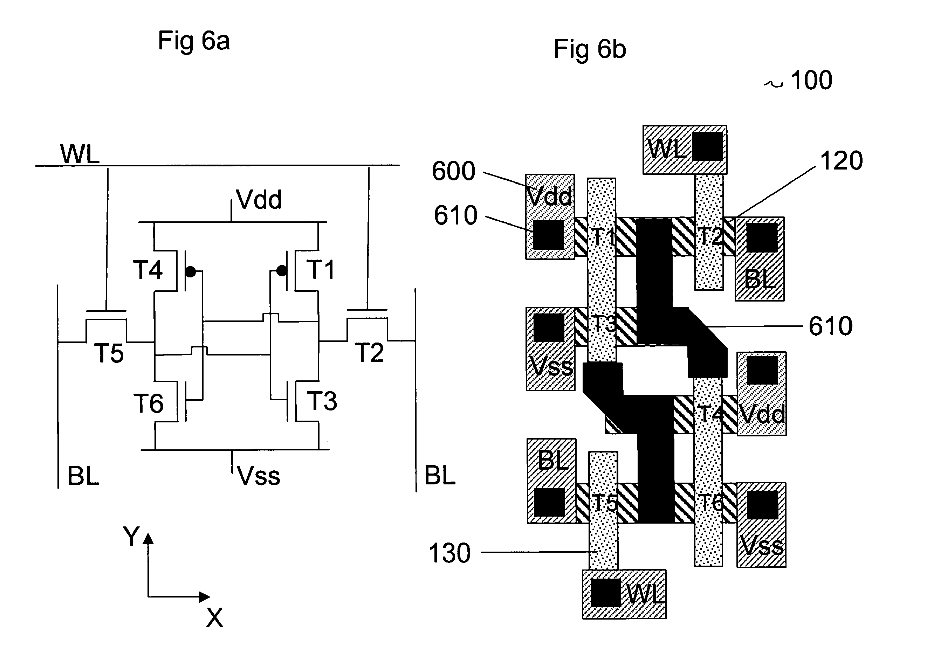

In a third embodiment of the present invention, a method is described for manufacturing a memory or logic circuit using a method for forming a pattern as described in any of the first or second embodiment, comprising the same features and advantages. This third embodiment is illustrated in figs. 6a-d. By way of illustration, a method for manufacturing an SRAM comprising fin-based transistor devices, e.g. finFET devices, is illustrated. Static Random Access Memory cells (SRAM) are programmed by changing the status of a logic circuit. The logic circuit is a bistable logic circuit that can flip, when addressed, from one logic to another. Various layouts of SRAM memory cells are know.

In fig. 6a the electric equivalent circuit of a SRAM cell is shown. For teaching the invention an SRAM memory cell containing 6 transistors is used. The present invention nevertheless is not limited thereto. The 6 transistors are configured as two invertors interconnected to form the bistable logic circuit and as two select transistors for accessing the logic circuit. Transistors T5 and T2 are used to address the SRAM cell, while two invertors are coupled within the SRAM. A first inverter is formed by transistors T4 and T6 while a second inverter is formed by transistors T1 and T3. Transistors T4, T5, T6 share a common pad while transistors T4 and T6 have a common control electrode, e.g. gate electrode. Transistors T1, T2, T3 share a common pad while transistors T1 and T3 have a common control electrode, e.g. gate electrode. The control electrode, e.g. gate electrode of transistors T1, T3 is connected with the common pad of transistors T4, T5, T6. The control electrode, e.g. gate electrode, of transistors T4, T6 is connected with the common pad of transistors T1, T2, T3. The other pad of nMOS transistors T5 and T2 are connected to the respective bitlines BL, while the control electrodes, e.g. gate electrodes, of both transistors T5 and T2 are connected to the common wordline WL. The pad shared between transistors, e.g. nMOS transistors, T6 and T3 is connected to the ground line Vss, while the pad shared between transistors, e.g. pMOS transistors, T4 and T1 is connected to the supply voltage line Vdd.

Fig. 6b shows a schematic top view of the layout of the SRAM cell (100) of fig. 6a with fin level (120, area thick lines dashed top left to bottom right), gate electrode (130, dotted area), contact (610, black area) and a first metal level, e.g. metal level 1 (600, area dashed top right to bottom left). When manufacturing the SRAM layout with the given layout for the semiconductor material (320) to define the fin (120), the layout for the polycrystalline silicon to define the control electrodes, e.g. gate electrodes (130), the contacts (600) connecting fins (120), metal lines (610) and the first metal level to define the first metal wiring (610), at each device level (fins, gates, contact, metal lines) the pattern will be defined in the corresponding material layers in a single patterning step. In order to make a connection between the control electrode, e.g. gate electrode, of transistors T1 and T3 with the common pad of transistors T4, T5, T6 a "boomerang" like contact is to be formed. Likewise a "boomerang" like contact is to be formed to connect the gate electrode of transistors T4 and T6 with the common pad of transistors T1, T2, T3. Consequently no metal wiring in a first metal level can run over these contact boomerangs as an unwanted contact would be made between these contact boomerangs and the first metal level. The wordline WL which controls the access transistors T2 and T5 must therefore be formed in a higher metal level, e.g. second metal level, which can run over the contact boomerangs but being isolated therefrom by intermediate dielectric layers. The bitlines BL, the supply voltage line Vdd and the ground line Vss must run in metal lines at an even higher metal line, e.g. a third metal, e.g. metal 3. In this case the corresponding Vdd contacts of e.g. transistors T1 and T4 can be contacted by a metal line running across the SRAM cell, but electrically isolated from the underlying wordline in the second metal, i.e. metal 2 and contact boomerangs.

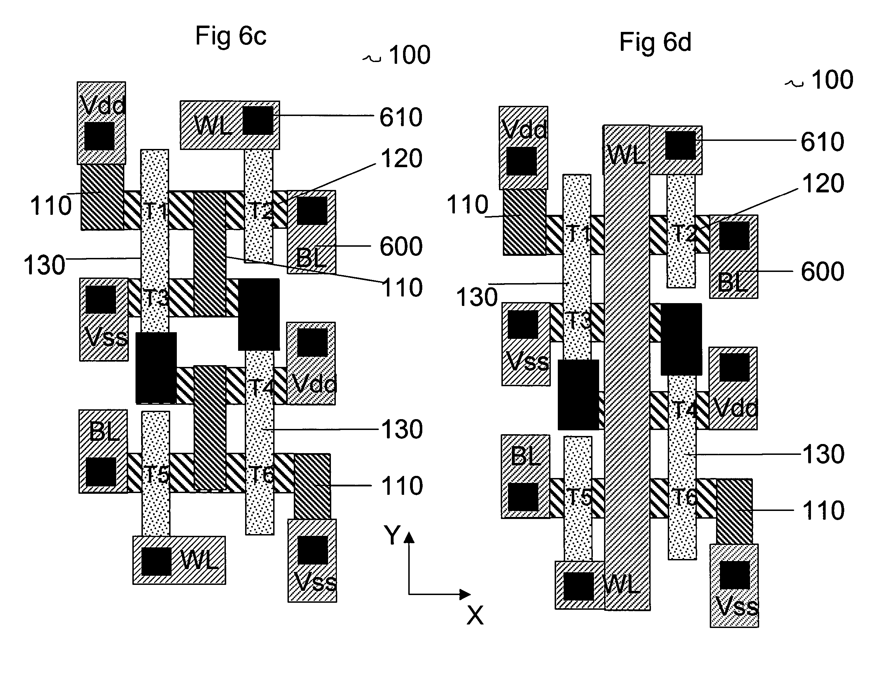

Fig. 6c shows a schematic top view of the layout of the SRAM cell (100) of fig. 6a. The layout of device level corresponding to the semiconductor material (320) is now split in two subpatterns. A first subpattern (200) contains the fins (120, area thick lines dashed top left to bottom right) which are oriented in horizontal direction (X-direction). This subpattern is most critical as the elements thereof have the minimal dimensions, e.g. the channels of the transistors. A second subpattern (210) contains the pads (110, area thin lines dashed top left to bottom right) connecting fins (120). These pads are essentially oriented in vertical direction (Y-direction). This subpattern is less critical as it is only used to establish a local interconnect, a contact between adjacent fins and/or control electrodes, e.g. gate electrodes without metal wiring. Also control electrodes, e.g. gate electrodes (130, dotted area), contacts (610, black area) and metal lines formed in first metal level (600, area dashed top right to bottom left) are shown. When manufacturing the SRAM layout with the layout for the semiconductor material (320) to define the fin (120) and the pads (110) the double exposure lithographic step of the first or second embodiment will be use, while for the layout of the polycrystalline silicon to define the control electrodes, e.g. gate electrodes (130), the contacts (600) connecting fins (120), metal lines (610) and the first metal level to define the first metal wiring (610), at each device level (control electrodes e.g. gates, contact, metal lines) the pattern will be defined in the corresponding material layers in a single patterning step, in e.g. respectively polycrystalline silicon, dielectric materials, metal lines or dielectric materials in case of damascene processing of interconnect wiring. In order to make a connection between the control electrode, e.g. gate electrode of transistors T1 and T3 with the common pad of transistors T4, T5, T6 a pad (110) is formed. Likewise a pad (110) formed to connect the control electrode, e.g. gate electrode, of transistors T4 and T6 with the common pad of transistors T1, T2, T3. Consequently metal wiring (not shown in fig. 6c) in a first metal level can run over these pads (110) to contact the correspond WL contacts of the access transistors T2 and T5. The bitlines BL, the supply voltage line Vdd and the ground line Vss can run in metal lines at subsequent metal level, e.g. second metal level. In this case the corresponding Vdd contacts of e.g. transistors T1 and T4 can be contacted by a metal line at a higher metal level running across the SRAM cell, but electrically isolated from the underlying wordline in metal 1.

Fig. 6d is the schematic top view of the layout of the SRAM cell (100) of fig. 6a partially shown in fig. 6c. The layout of device level corresponding to the semiconductor material (320) is now split in two subpatterns. A first subpattern (200) contains the fins (120, area thick lines dashed top left to bottom right) which are oriented in horizontal direction (X-direction). This subpattern is most critical as the elements thereof have the minimal dimensions, e.g. the channels of the transistors. A second subpattern (210) contains the pads (110, area thin lines dashed top left to bottom right) connecting fins (120). These pads are essentially oriented in vertical direction (Y-direction). This subpattern is less critical as it is only used to establish a local interconnect, a contact between adjacent fins and/or gate electrodes without metal wiring. In other words, an interconnection between two elements of the circuit is made in the device layers that are used to make elements of the circuit. Also control electrodes, e.g. gate electrodes (130, dotted area), contacts (610, black area) and metal lines formed in first metal level (600, area dashed top right to bottom left) are shown. When manufacturing the SRAM layout with the layout for the semiconductor material (320) to define the fin (120) and the pads (110) the double exposure lithographic step of the first or second embodiment will be use, while for the layout of the polycrystalline silicon to define the gate electrodes (130), the contacts (600) connecting fins (120), control electrodes, e.g. gate electrodes (130), metal lines (610) and the first metal level to define the first metal wiring (610), at each device level (gates, contact, metal lines) the pattern will be defined in the corresponding material layers in a single patterning step, in e.g. respectively polycrystalline silicon, dielectric materials, metal lines or dielectric materials in case of damascene processing of interconnect wiring. In order to make a connection between the gate electrode of transistors T1 and T3 with the common pad of transistors T4, T5, T6 a pad (110) is formed. Likewise a pad (110) formed to connect the gate electrode of transistors T4 and T6 with the common pad of transistors T1, T2, T3. Consequently metal wiring in a first metal level can run over these pads (110) to contact the corresponding WL contacts of the access transistors T2 and T5. Now the metal line connecting the contact to the wordline WL of transistor T2 and T5 can be formed in the first metal level and run in vertical direction over the middle of the SRAM cell. As no contacts are present in this middle part no unwanted connection can be made with the metal 1 wordline WL. The bitlines BL, the supply voltage line Vdd and the ground line Vss can now be formed in a second metal level instead of in a third metal level as was the case for the layout shown in fig. 6b. Hence manufacturing of a dense pattern in a device level according to a first or a second embodiment reduces the number of metal levels needed.

In a fourth embodiment, the second aspect of the present invention relates to a memory or logic circuit typically comprising at least one device layer wherein the elements of the circuit are made and at least one metal layer for wiring different elements of the circuit. The circuit furthermore comprises a local interconnect connecting at least two elements of said plurality of elements, said local interconnect being formed in one of said at least one device layers. The memory or logic circuit may be obtained according to a method as described in the third embodiment. The memory or logic circuit may be a memory device, such as a static random access memory, a dynamic random access memory, a flash memory, etc. It may e.g. be an SRAM comprising finFET devices. The memory or logic circuit may be a circuit as resulting from the manufacturing steps shown in Fig. 3a-e, Fig. 5a-e or Fig. 6a-d.

It is to be understood that although preferred embodiments, specific constructions and configurations, as well as materials, have been discussed herein for devices according to the present invention, various changes or modifications in form and detail may be made without departing from the scope and spirit of this invention.

## Claims

1. A method of forming a pattern (100) in a substrate (300), the pattern (100) having elements oriented along at least a first direction and elements oriented along a second direction, said first direction being substantially orthogonal to said second direction, the method comprising:
- forming a hard mask layer (330, 500) on the substrate (300),
- forming in the hard mask layer (330, 500) a pattern of elements oriented in said first direction,
- lithographic processing the substrate (300) with a pattern of elements oriented in the second direction, and
- etching the substrate (300).

2. The method of claim 1, comprising, prior to said forming a pattern in the hard mask layer, generating a first mask (200) comprising elements (120) of the pattern (100) oriented in said first direction, and, prior to said lithographic processing the substrate, generating a second mask (210) comprising elements (110) of the pattern (100) oriented in said second direction.

3. The method of any of the foregoing claims, wherein the step of forming in the hard mask layer (330) a pattern of elements oriented in said first direction comprises:
- patterning the hard mask layer (330) according to an intermediate pattern,
- forming another hard mask layer overlying the hard mask layer (400) patterned according to an intermediate pattern,
- forming sidewall spacers (500) against the hard mask layer (400) patterned according to an intermediate pattern,
- removing the hard mask layer (400) patterned according to an intermediate pattern.

4. The method of any of the claims 1 or 2, wherein the step of forming in the hard mask layer (330) a pattern of elements oriented in said first direction comprises:
- forming a photosensitive layer (340) over the hard mask layer (330),
- exposing the photosensitive layer (340) with the pattern (200) of elements oriented in said first direction, and
- etching the hard mask layer (330).

5. The method of any of the foregoing claims, wherein the step of lithographic processing the substrate (300) comprises:
- forming a photosensitive layer (350) over the patterned hard mask layer (330, 500), and
- exposing the photosensitive layer (350) with the pattern (210) of elements oriented in the second direction.

6. The method according to any of the foregoing claims, wherein forming the pattern (100) in a substrate (300) comprises or consists of forming a local interconnect between two elements of an integrated circuit.

7. The method according to claim 6, wherein the two elements of an integrated circuit are two elements made of a same device layer and said local interconnect is made in said same device layer.

8. The method according to any of claims 6 and 7, the integrated circuit comprising a fin-based transistor element, the integrated circuit comprising fin regions (120), wherein said fin regions (120) are connected by said local interconnect formed in a semiconducting layer (320).

9. The method according to any of claims 6 to 8 wherein the substrate (300) is a semiconductor-on-insulator substrate and the semiconducting layer (320) is the semiconductor layer of the semiconductor-on-insulator substrate.

10. A memory or logic circuit, the circuit comprising at least one device layer and at least one metal layer for wiring different elements of the circuit, the circuit comprising a plurality of elements made in said at least one device layer, wherein said circuit furthermore comprises a local interconnect connecting at least two elements of said plurality of elements, said local interconnect being formed in one of said at least one device layers.

11. A memory or logic circuit according to claim 10, the circuit comprising a plurality of fin-based transistors, said fin-based transistors comprising a fin region and a control electrode, wherein said at least two elements connected by said local interonnect are any of at least two fin regions, a fin region and a control electrode or at least two control electrodes.

12. A memory or logic circuit according to claim 11, wherein said fin-based transistors are finFET devices and said control electrode(s) are gate electrode(s).

13. A memory or logic circuit according to any of claims 10 to 12, wherein said at least two elements are made in the same device layer and wherein said local interconnect is made in the same device layer as said at least two elements.

14. A memory or logic circuit according to any of claims 10 to 13, the memory or logic circuit consisting of a static random access memory cell.

15. A memory or logic circuit according to claim 14, wherein the static random access memory cell comprises a plurality of finFET devices configured to form a bistable element and to form two select transistors (T2, T5) for accessing the bistable element, wherein
- gate electrodes of the two select transistors (T2, T5), are connected at a first metal level (600) using a first metal connection running over the SRAM memory cell and
- connections (110) between respective fins (120) of the bistable element (T4-T6, T1-T3) are formed in a same material (320) wherein said fins are formed.

16. A memory or logic circuit according to claim 14, wherein the static random access memory cell comprises two invertors (T4-T6, T1-T3) comprising transistors T1, T3, T4 and T6, and two pass transistors (T5, T2) for contacting the two invertors, whereby transistors T4, T5, T6 share a common pad while transistors T4 and T6 have a common gate electrode, transistors T1, T2, T3 share a common pad while transistors T1 and T3 having a common gate electrode, the gate electrode of transistors T1, T3 being connected with the common pad of transistors T4, T5, T6, the gate electrode of transistors T4, T6 being connected with the common pad of transistors T1, T2, T3, the other pad of nMOS transistors T5 and T2 being connected to bitlines BL, the gate electrodes of both transistors T5 and T2 being connected to a common wordline WL, the pad shared between nMOS transistors T6 and T3 being connected to a ground line Vss, while the pad shared between pMOS transistors T4 and T1 being connected to the supply voltage line Vdd,
characteristed in that
- the connection between the gate electrode of transistors T1, T3 and the common pad of transistors T4, T5, T6, and the connection between the gate electrode of transistors T4, T6 and the common pad of transistors T1, T2, T3 is formed in a device layer (320), and
- the connection between the gate electrodes of both transistors T5 and T2 and a common wordline WL being formed in a first metal level.
